# EUROPÄISCHE PATENTSCHRIFT

(11) **EP 0 671 874 B1**
(45) Veröffentlichungstag und Bekanntmachung des Hinweises auf die Patenterteilung: **04.09.1996**
(21) Anmeldenummer: 95102323.3
(22) Anmeldetag: 20.02.1995
(51) Int. Cl.: H05K 9/00

(54) **Einrichtung zur Abschirmung von auf einer Elektronikkarte angeordneten elektronischen Bauteilen gegen äussere, elektromagnetische Felder**
Device for shielding of electronic components mounted on a board against exterior electromagnetic fields
Dispositif pour le blindage de composants électroniques arranges sur une carte contre les champs électromagnétiques extérieurs

(30) Priorität: 07.03.1994 DE 4407492
(43) Veröffentlichungstag der Anmeldung: 13.09.1995
(73) Patentinhaber: Bodenseewerk Gerätetechnik GmbH, 88662 Überlingen (DE)
(72) Erfinder: Acatay, Murat, D-78315 Radolfzell (DE); Helfer, Winfried, D-78239 Reilasingen (DE); Kienle, Gerhard, D-88682 Salem (DE)
(74) Vertreter: Weisse, Jürgen, Dipl.-Phys. Patentanwalt

(56) Entgegenhaltungen:
- EP-A- 0 350 775
- WO-A-92/16095
- US-A- 4 739 453

## Beschreibung

Die Erfindung betrifft eine Einrichtung zur Abschirmung von auf einer Elektronikkarte angeordneten elektronischen Bauteilen gegen äußere, elektromagnetische Felder mit einem elektromagnetische Felder abschirmenden Gehäuse, das einen elektromagnetische Felder enthaltenden ersten Raum und einen abgeschirmten zweiten Raum bildet, wobei Zuleitungen zu den elektronischen Bauteilen in den ersten Raum eingeleitet werden, mit einer mehrschichtigen, mit einer internen Massefläche versehenen Leiterplatte mit Filterbauteilen, die den ersten Raum begrenzt und Durchkontaktierungen zum Hindurchführen der Zuleitungen in den zweiten Raum.

Eine solche Einrichtung ist bekannt durch die EP-B-0 350 775 (= US-A-4 945 323).

Empfindliche elektronische Geräte, beispielsweise Flug- oder Triebwerksrechner von Flugzeugen, sind in einem gegen elektromagnetische Felder abgeschirmten Raum untergebracht. Zu diesen Geräten sind Zuleitungen geführt. Die Zuleitungen kommen aus einem Raum, in welchem starke elektrische oder magnetische Felder hoher Frequenz auftreten können. Die Zuleitungen führen Nutzsignale. Diese Nutzsignale können sowohl analoge Signale als auch digitale Impulsfolgen sein.

Über diese Leitungen können störende elektromagnetische Felder in den abgeschirmten Raum gelangen. In den Leitungen können dann Signale induziert werden, die den Nutzsignalen überlagert sind und die Signalverarbeitung übersteuern oder "verstopfen".

Die EP-B-0 350 775 sieht daher eine Filteranordnung zur Filterung einer Mehrzahl von Leitungen vor, die aus einem elektromagnetische Felder enthaltenden Raum durch eine mehrschichtige Leiterplatte hindurch zu einem in einem abgeschirmten Raum befindlichen Gerät geführt sind. Die Leiterplatte enthält eine durchgehende, interne Massefläche. Die Massefläche weist als Signaldurchführmittel enge Durchbrüche auf, durch welche Durchkontaktierungen (Durchsteiger) mit geringem Abstand von den Rändern der Durchbrüche hindurchgeführt sind. Elektrisch leitende Flächen auf denjenigen Schichten, die an die Massefläche angrenzen, bilden mit der Massefläche Filter-Kondensatoren. Die Flächen sind mit den Durchkontaktierungen verbunden. Filterbauteile sind als SMD-Bauteile ausgebildet und auf der Leiterplatte montiert. Die Massefläche ist an den Rändern der Leiterplatte nach außen geführt. Die Ränder der Leiterplatte sind rundum verkupfert und gut leitend mit dem Gehäuse verbunden.

Bei der EP-A-0,350 775 (= US-A-4 945 323) dient die erwähnte Leiterplatte ausschließlich als Trennwand, die einen elektromagnetische Felder enthaltenden "schmutzigen" Raum von einem abgeschirmten "sauberen" Raum zu trennen. Das eigentliche Gerät sitzt auf gesonderten Leiterplatten in dem "sauberen" Raum.

Der Erfindung liegt die Aufgabe zugrunde eine Einrichtung der eingangs genannten Art so auszubilden, daß eine einzige Leiterplatte sowohl eine Trennung zwischen "schmutzigem" und "sauberem" Raum vornimmt als auch Bauteile des abzuschirmenden Geräts selbst aufnimmt.

Erfindungsgemäß wird diese Aufgabe dadurch gelöst, daß
(a) die Leiterplatte einen ersten Bereich aufweist, der die Filterbauteile trägt und einen zweiten Bereich der abzuschirmende elektronische Bauteile trägt,
(b) das Gehäuse eine abschirmende Trennwand bildet, die sich bis zu der Leiterplatte erstreckt und zwischen erstem und zweitem Bereich an der Leiterplatte anliegt, wobei der erste Raum von dem ersten Bereich der Leiterplatte begrenzt ist,
(c) in der Leiterplatte im Bereich der Trennwand quer zur Oberfläche der Leiterplatte sich erstreckende Abschirmmittel zum Abschirmen elektromagnetischer Felder vorgesehen sind,
(d) die Zuleitungen über Durchkontaktierungen isoliert durch die Massefläche hindurchgeführt sind und
(e) die Zuleitungen weiterhin auf der dem ersten Raum abgewandten Seite der Massefläche in der Leiterplatte isoliert durch die quer zur Oberfläche der Leiterplatte sich erstreckenden Abschirmmittel hindurch zu den elektrischen Bauteilen geführt sind.

Ausgestaltungen der Erfindung sind Gegenstand der Unteransprüche.

Ein Ausführungsbeispiel der Erfindung ist nachstehend unter Bezugnahme auf die zugehörigen Zeichnungen näher erläutert.
- Fig.1: zeigt einen Schnitt längs der Linie I - I von Fig.2 durch eine Einrichtung zur Abschirmung von auf der Elektronikkarte angeordneten elektronischen Bauteilen gegen äußere, elektromagnetische Felder.
- Fig.2: ist ein Schnitt längs der Linie II-II von Fig.1.

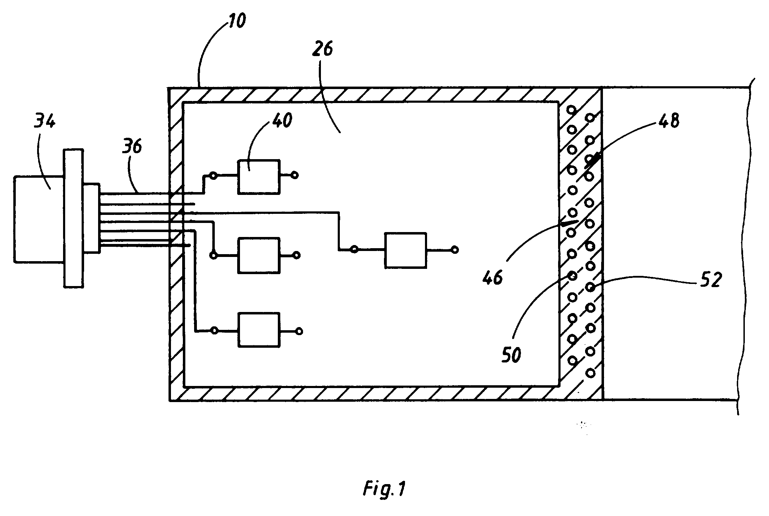

In Fig.1 ist mit 10 ein rechteckiges Gehäuse aus einem abschirmenden Material bezeichnet. Das Gehäuse 10 weist auf der Innenseite eine Leiste 12 mit einer unteren Anlagefläche 14 auf. Das Gehäuse 10 bildet eine Trennwand 16. Die Trennwand 16 verläuft parallel zu der die Leiste 12 aufweisenden Stirnwand 18. Die Trennwand 16 ragt in den Innenraum des Gehäuses 10. Eine Stirnfläche 20 der Trennwand 16 liegt in der Ebene der Anlagefläche 14 der Leiste 12. An der Anlagefläche 14 und der Stirnfläche 20 liegt eine Elektronikkarte in Form einer mehrschichtigen Leiterplatte 22 an.

Die Leiterplatte 22 bildet mit dem Gehäuse 10 und der Trennwand 16 einen ersten Raum 24. Der erste Raum 24 grenzt dabei an einen ersten Bereich 26 der Leiterplatte 22 an. Der erste Raum 24 ist, wie noch erläutert wird, ein "schmutziger" Raum, in welchem elektromagnetische Felder auftreten können. Ein zweiter Raum 28 wird auf der dem ersten Raum 24 abgewandten Seite der Trennwand 16 von dem Gehäuse 10, der Trennwand 16 und einem zweiten Bereich 30 der Leiterplatte 22 begrenzt. Der zweite Raum 28 ist ein gegen störende elektromagnetische Felder abgeschirmter "sauberer" Raum. Ein sauberer Raum 32 ist auch unterhalb der Leiterplatte 22 gebildet. Dort können weitere (nicht dargestellte) Bauteile und Leiterplatten des abzuschirmenden Gerätes untergebracht werden.

In der den ersten Raum 24 begrenzenden Wandung des Gehäuses 10 sitzt ein Gerätestecker 34. Der Gerätestecker 34 enthält Anschlüsse für eine Mehrzahl von Zuleitungen 36. Die Zuleitungen 36 führen Signale zu einem abgeschirmten Gerät oder von diesem weg nach außen. Elektronische Bauteile 38 des abgeschirmten Gerätes sind in dem zweiten Raum 28 auf der Oberfläche im zweiten Bereich 20 der Leiterplatte 22 montiert.

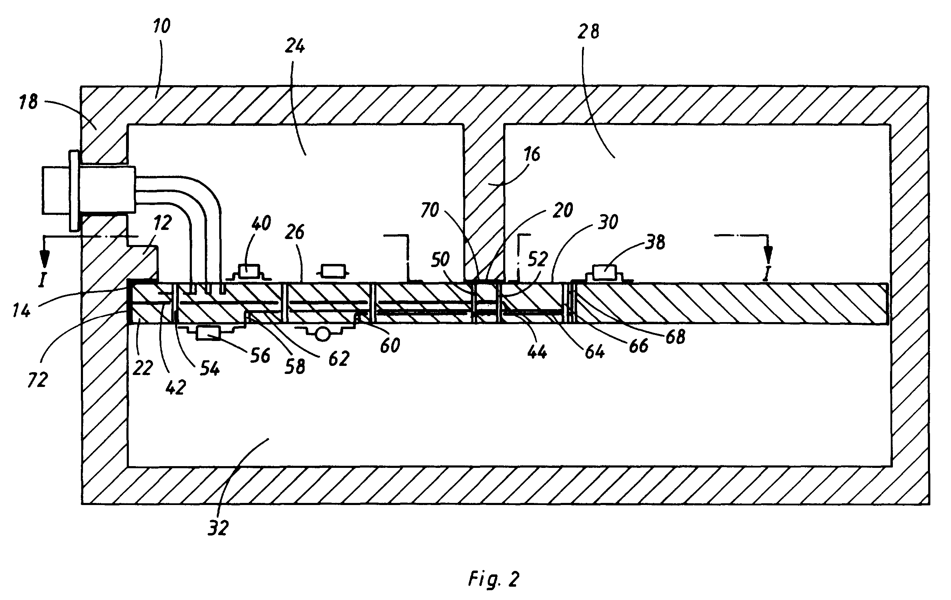

Über die Zuleitungen 36 gelangen hochfrequente elektromagnetische Felder in den ersten Raum 24. In dem ersten Raum 24 sind Filterbauteile 40 angeordnet, durch welche hochfrequente Signalanteile auf den Zuleitungen unterdrückt und zur Masse abgeleitet werden. Die Leiterplatte 22 weist eine interne Massefläche 42 auf. Die interne Massefläche 42 ist eine geerdete Metallschicht auf zwischen zwei Schichten der mehrschichtigen Leiterplatte 22. Die Massefläche 42 erstreckt sich im wesentlichen durchgehend über den gesamten ersten Bereich 26 der Leiterplatte 22. Der zweite Bereich 30 der Leiterplatte 22 enthält keine derartige Massefläche. Die Massefläche 42 ist in noch zu beschreibender Weise mit dem Gehäuse 10 verbunden. Die Massefläche 42 bewirkt eine Abschirmung der elektromagnetischen Strahlung aus dem ersten Raum 23 nach unten in Fig.2.

Im Bereich der Trennwand 16 sind quer zur Oberfläche der Leiterplatte 22 sich erstreckende Abschirmmittel 44 zum Abschirmen elektromagnetischer Felder vorgesehen, die oberhalb der Massefläche 42 in der Leiterplatte 22 in den zweiten Raum 28 gelangen könnten. Die Abschirmmittel 44 sind durch längs der Trennlinie zwischen erstem und zweitem Bereich 26 bzw. 30 verlaufenden Reihen 46 und 48 von Durchkontaktierungen 50 bzw. 52 der Leiterplatte 22 gebildet. Speziell sind die Abschirmmittel 44 von zwei auf Lücke angeordneten, parallelen Reihen 46 und 48 von Durchkontaktierungen 50 bzw. 52 der Leiterplatte 22 gebildet. Diese Abschirmmittel 44 schirmen den zweiten Raum 28 gegen störende elektromagnetische Strahlung aus dem ersten Raum 24 ab. Die Abschirmmittel 44 schirmen auch den "sauberen" Raum 32 gegen den Raum 24 ab.

Die Zuleitungen 36 sind auf folgende Weise aus dem ersten Raum 24 zu den elektronischen Bauteilen 38 geführt:

Nach der Filterung durch die im "schmutzigen" Raum angeordneten Filterbauteile 40 sind die Zuleitungen über Durchkontaktierungen 54 in den abgeschirmten, "sauberen" Raum 32 geführt. Die Durchkontaktierungen 54 sind durch Durchbrüche der Massesfläche 42 hindurchgeführt. Die Ränder der Durchbrüche haben dabei einen geringen Abstand von den Durchkontaktierungen 54, so daß kein elektrischer Kontakt erfolgt aber praktisch keine elektromagnetischen Felder dort hindurchtreten können. In dem Raum 32 erfolgt eine Filterung der Signale durch Filterbauteile 56, die im ersten Bereich 26 auf der an den Raum 32 angrenzenden Unterseite der Leiterplatte 22 sitzen. Von der Unterseite der Leiterplatte 22 her sind in dem ersten Bereich 26 in der Leiterplatte Sackloch-Kontaktierungen 58, 60 vorgesehen. Diese SacklochKontaktierungen 58, 60 stellen eine Verbindung zwischen den auf der Unterseite der Leiterplatte 22 verlaufenden Abschnitten der Zuleitungen 36 und Leiterbahnen 62 bzw 64 her. Die Leiterbahnen 62 und 64 verlaufen "unterhalb" der Massefläche zwischen verschiedenen Schichten der mehrschichtigen Leiterplatte 22 und laufen isoliert zwischen benachbarten Durchkontaktierungen 50 und 52 der Abschirmmittel 44 hindurch in den zweiten Bereich 30 hinein. Die Leiterbahnen 62 und 64 sind wieder mit Durchkontaktierungen 66 bzw. 68 in dem zweiten Bereich 30 verbunden. Die Durchkontaktierungen 66 und 68 sind mit Anschlüssen von elektronischen Bauteilen 38 verbunden. Die elektronischen Bauteile 38 sind, wie geschildert, in dem abgeschirmten zweiten Raum 28 aber auf der gleichen Leiterplatte angeordnet, die auch die Massefläche 42 aufweist und die Filterglieder 40, 56 trägt.

Die abschirmende Trennwand 16 liegt mit ihrer Stirnfläche 20 an einer Leiterbahn 70 auf der Oberfläche der Leiterplatte 22 an. Die Leiterbahn 70 ist mit den sich quer zur Oberfläche der Leiterplatte 22 erstreckenden Abschirmmitteln 44 in Kontakt. Weiterhin weist die Leiterplatte 22 an einer Stirnfläche eine elektrisch Leitende Fläche 72 auf, die einerseits an der Innenseite des Gehäuses 10 anliegt und andererseits mit der internen Massefläche 42 der Leiterplatte 22 in Kontakt ist.

Die Leiterplatte kann Filterkomponenten zum Schutz gegen Überspannung (Blitzschutz) enthalten.

Die Filterbandbreite muß sich in vielen Fällen bis zu 40 GHz erstrecken (RADAR). Das läßt sich mit diskreten Filterkomponenten nicht erreichen. Die Leiterplatte 22 kann daher weiterhin Filterglieder in Form von Leiterbahnen (Spulen, Kondensatoren) innerhalb der Leiterplatte 22 enthalten.

## Patentansprüche

1. Einrichtung zur Abschirmung von auf einer Elektronikkarte (22) angeordneten elektronischen Bauteilen (38) gegen äußere, elektromagnetische Felder mit einem elektromagnetische Felder abschirmenden Gehäuse (10), das einen elektromagnetische Felder enthaltenden ersten Raum (24) und einen abgeschirmten zweiten Raum (28) bildet, wobei Zuleitungen (36) zu den elektronischen Bauteilen (38) in den ersten Raum (24) eingeleitet werden, mit einer mehrschichtigen, mit einer internen Massefläche (42) versehenen Leiterplatte (22), die den ersten Raum (24) begrenzt und Durchkontaktierungen (54) zum Hindurchführen der Zuleitungen (36) in den zweiten Raum (28), **dadurch gekennzeichnet, daß**
(a) die Leiterplatte (22) einen ersten Bereich (26) aufweist, der die Massefläche aufweist und einen zweiten Bereich (30) der abzuschirmende elektronische Bauteile (38) trägt,
(b) das Gehäuse (10) eine abschirmende Trennwand (16) bildet, die sich bis zu der Leiterplatte (22) erstreckt und zwischen erstem und zweitem Bereich (26 bzw. 30) an der Leiterplatte (22) anliegt, wobei der erste Raum (24) von dem ersten Bereich (26) der Leiterplatte (22) begrenzt ist,
(c) in der Leiterplatte (22) im Bereich der Trennwand (16) quer zur Oberfläche der Leiterplatte (22) sich erstreckende Abschirmmittel (44) zum Abschirmen elektromagnetischer Felder vorgesehen sind,
(d) die Zuleitungen (36) über Durchkontaktierungen (54) isoliert durch die Massefläche (42) hindurchgeführt sind und
(e) die Zuleitungen (36) weiterhin auf der dem ersten Raum (24) abgewandten Seite der Massefläche (42) in der Leiterplatte (22) isoliert durch die quer zur Oberfläche der Leiterplatte (22) sich erstreckenden Abschirmmittel (44) hindurch zu den elektrischen Bauteilen (38) geführt sind.

2. Einrichtung nach Anspruch 1, **dadurch gekennzeichnet, daß** die Leiterplatte (22) in dem ersten Bereich Filterglieder (40,56) trägt.

3. Einrichtung nach Anspruch 1 oder 2, **dadurch gekennzeichnet, daß** die Leiterplatte Filterglieder in Form von Leiterbahnen, wie z.B. Spulen, Kondensatoren, innerhalb der Leiterplatte enthält.

4. Einrichtung nach einem der Ansprüche 1 bis 3, **dadurch gekennzeichnet, daß** die Abschirmmittel (44) durch mindestens eine längs der Trennlinie zwischen erstem und zweitem Bereich (26 bzw. 30) verlaufende Reihe (46,48) von Durchkontaktierungen (50,52) der Leiterplatte (22) gebildet sind.

5. Einrichtung nach Anspruch 4, **dadurch gekennzeichnet, daß** die Abschirmmittel (44) von wenigstens zwei auf Lücke angeordneten, parallelen Reihen (46,48) von Durchkontaktierungen (50,52) der Leiterplatte (22) gebildet sind.

6. Einrichtung nach einem der Ansprüche 1 bis 4, **dadurch gekennzeichnet, daß** erste Filterbauteile (40) zum Ableiten von hochfrequenten elektrischen Feldern auf der Leiterkarte (22) in dem ersten Raum (24) und zweite Filterbauteile (56) zum Ableiten hochfrequenter elektrischer Felder ebenfalls auf der Leiterkarte (22) auf deren dem ersten Raum (24) abgewandten Seite in dem ersten Bereich (26) angeordnet sind.

7. Einrichtung nach einem der Ansprüche 1 bis 6, **dadurch gekennzeichnet, daß** in dem ersten Bereich (26) auf der dem ersten Raum (24) abgewandten Seite Kontaktierungen (58,60) vorgesehen sind, die einerseits mit jeweils einer durchgeführten Zuleitung (36) und andererseits mit einer isoliert durch die Abschirmmittel (44) hindurchgeführten Leiterbahn (62,64) der Leiterplatte (22) verbunden sind, wobei diese Leiterbahn (62,64) ihrerseits über eine Kontaktierung (66,68) mit wenigstens einem der abzuschirmenden elektronischen Bauteile (38) verbunden ist.

8. Einrichtung nach Anspruch 7, **dadurch gekennzeichnet, daß** die Kontaktierungen (58,60) in dem ersten Bereich (26) von Sackloch-Kontaktierungen gebildet sind, die nur auf der dem ersten Raum (24) abgewandten Seite der Massefläche (42) verlaufen.

9. Einrichtung nach einem der Ansprüche 1 bis 8, **dadurch gekennzeichnet, daß** die abschirmende Trennwand (16) mit ihrer Stirnfläche (20) an einer Leiterbahn (70) auf der Oberfläche der Leiterplatte (22) anliegt, die mit den sich quer zur Oberfläche der Leiterplatte (22) erstreckenden Abschirmmitteln (44) in Kontakt ist.

10. Einrichtung nach Anspruch 9, **dadurch gekennzeichnet, daß** die Leiterplatte (22) wenigstens an einer Stirnfläche eine elektrisch leitende Fläche (72) aufweist, die einerseits an der Innenseite des Gehäuses (10) anliegt und andererseits mit der internen Massefläche (42) der Leiterplatte (22) in Kontakt ist.

11. Einrichtung nach einem der Ansprüche 1 bis 10, **dadurch gekennzeichnet, daß** die Leiterplatte Filterkomponenten zum Schutz gegen Überspannung, zum Beispiel Blitzschutz, enthält.

## Claims

1. Device for the shielding of electronic components (38) arranged on a printed circuit board (22) from outside electromagnetic fields, comprising a housing (10) shielding from electromagnetic fields, which defines a first chamber (24) exposed to electromagnetic fields and a shielded second chamber (28), connecting lines (36) leading to the electronic components (38) extending into the first chamber (24), and comprising a multi-layer printed circuit board (22) provided with an internal, grounded conductive coating (42) which limits the first chamber (24) and includes through contacts (54) for passing the connecting lines (36) into the second chamber (28), **characterized in that**
(a) the printed circuit board (22) has a first region (26) which is provided with the grounded conductive coating (42) and a second region (30) which carries the electronic components (38) to be shielded,
(b) the housing (10) forms a shielding partition (16) which extends transversely to the surface of the printed circuit board (22) and engages the printed circuit board (22) between the the first and second regions (26 and 30, respectively), the first chamber (24) being limited by the first region (26) of the printed circuit board (22),
(c) shielding means (44) for blocking electromagnetic fields are provided in the printed circuit board (22) adjacent the partition (16), the shielding means extending transversely to the surface of the printed circuit board (22),
(d) the connecting lines (36) are passed through through-contacts insulatedly through the grounded conductive coating (42), and
(e) the connecting lines (36), furthermore, extend in the printed circuit board (22) on the side of the grounded conductive coating (42) remote from the first chamber (24) and insulatedly through the shielding means extending transversely to the surface of the printed circuit board to the electronic components (38).

2. Device as claimed in claim 1, **characterized in that** the printed circuit board (22) carries filter elements (40,56) in the first region.

3. Device as claimed in claim 1 or 2, **characterized in that** the printed circuit board incorporates filter elements in the form of conductor paths, such as, for example coils, capacitors, within the printed circuit board.

4. Device as claimed in anyone of the claims 1 to 3 **characterized in that** the shielding means (44) are formed by at least one row (46,48) of spaced through contacts (50,52) extending through the printed circuit board (22) along the partition line between the first and second regions (26 and 30, respectively).

5. Device as claimed in claim 4, **characterized in that** the shielding means (44) comprise at least two staggered parallel rows (46,58) of through-contacts (50,52) of the printed circuit board (22).

6. Device as claimed in anyone of the claims 1 to 4, **characterized in that** first filter components (40) for shunting high-frequency, electric fields are provided on the printed circuit board (22) within the first chamber (24), and second filter components (56) for shunting high-frequency electric fields are provided, also on the printed circuit board (22) on the side thereof remote from the first chamber (24) and in the first region (26).

7. Device as claimed in anyone of the claims 1 to 6, **characterized in that** contacting means (58,60) are provided on the printed circuit board in the first region (26) and on the side thereof remote from the first chamber (24), the contacting means, on one hand, being connected with a connection line forming part of a respective one of the connecting lines (36) and, on the other hand, being connected with a respective conductor path (62,64) of the printed circuit board (22), the conductor path (62,64) extending insulatedly through the shielding means (44) and being, in turn, connected through contacting means (66,68) with at least one of the electronic components (38) to be shielded.

8. Device as claimed in claim 7, **characterized in that** the contacting means (58,60) in the first region (26) are blind bore contacting means which extend only on the side of the grounded conductive coating (42) remote from the first chamber (24).

9. A device as claimed in anyone of the claims 1 to 8, **characterized in that** the end face (20) of the shielding partition (16) engages conductor path (70) on the surface of the printed circuit board (22), the conductor path being in contact with the shielding means (44) extending transversely to the surface of the printed circuit board (22).

10. Device as claimed in claim 9, **characterized in that** the printed circuit board has an electrically conductive coating (72) on at least one end face, the coating, on one hand, engaging the housing (10) at an inner surface thereof and, on the other hand, being in contact with the internal, grounded conductive coating (42).

11. Device as claimed in anyone of the claims 1 to 10, **characterized in that** the printed circuit board includes filter means for protecting the electronic components from excessive voltage, for example as lightning protector.

## Revendications

1. Installation destinée à protéger des composants électroniques (38) disposés sur une carte électronique (22) contre des champs électromagnétiques extérieurs, munie d'un boîtier (10) de protection contre des champs électromagnétiques qui forme un premier espace (24) comprenant des champs électromagnétiques et un second espace (28) protégé, des conducteurs d'amenée (36) menant aux composants électroniques (38) étant introduits dans le premier espace (24), installation munie d'une carte de circuits imprimés (22) multicouches pourvue d'une surface interne reliée à la masse (42) et délimitant le premier espace (24), et installation munie de trous métallisés (54) destinés à faire passer les conducteurs d'amenée (36) dans le second espace (28), **caractérisée par le fait que**
(a) la carte de circuits imprimés (22) présente un premier domaine (26), présentant la surface reliée à la masse, et un second domaine (30) portant des composants électroniques (38) à protéger,
(b) le boîtier (10) forme une paroi de séparation (16) protectrice qui s'étire jusqu'à la carte de circuits imprimés (22) et qui est adjacente à la carte de circuits imprimés (22) entre le premier et le second domaine (26 et 30 respectivement), le premier espace (24) étant délimité par le premier domaine (26) de la carte de circuits imprimés (22),
(c) des moyens protecteurs (44) s'étendant dans la carte de circuits imprimés (22) dans le domaine de la paroi de séparation (16) diagonalement par rapport à la surface de la carte de circuits imprimés (22) et destinés à la protection contre des champs électromagnétiques sont prévus,
(d) les conducteurs d'amenée (36) sont menés de façon isolée par l'intermédiaire de trous métallisés (54) à travers la surface reliée à la masse (42) et
(e) les conducteurs d'amenée (36) sont en outre menés, de façon isolée, dans la carte de circuits imprimés (22) du côté de la surface reliée à la masse (42) opposé au premier espace (24) à travers les moyens de protection (44) s'étendant diagonalement par rapport à la surface de la carte de circuits imprimés (22) vers les composants électroniques (38).

2. Installation selon la revendication 1, **caractérisée par le fait que** la carte de circuits imprimés (22) porte dans le premier domaine des membres filtrants (40,56).

3. Installation selon la revendication 1 ou 2, **caractérisée par le fait que** la carte de circuits imprimés comprend des membres filtrants sous forme de pistes conductrices, comme p. ex. des bobines, des condensateurs, situés à l'intérieur de la carte de circuits imprimés.

4. Installation selon l'une des revendications 1 à 3, **caractérisée par le fait que** les moyens protecteurs (44) sont formés par au moins une rangée (46,48) de trous métallisés (50,52) de la carte de circuits imprimés (22) qui s'étend le long de la ligne de séparation entre le premier et le second domaine (26 et 30 respectivement).

5. Installation selon la revendication 4, **caractérisée par le fait que** les moyens protecteurs (44) sont formés par au moins deux rangées parallèles (46,48) de trous métallisés (50,52) de la carte de circuits imprimés (22) qui sont disposées avec des écarts.

6. Installation selon l'une des revendications 1 à 4, **caractérisée par le fait que** des premiers composants filtrants (40), destinés à dévier des champs électriques à haute fréquence, sont disposés sur la carte de circuits imprimés (22) dans le premier espace (24) et des seconds composants filtrants (56), destinés à dévier des champs électriques à haute fréquence, sont également disposés sur la carte de circuits imprimés (22) sur le côté de cette dernière opposé au premier espace (24) dans le premier domaine (26).

7. Installation selon l'une des revendications 1 à 6, **caractérisée par le fait que** des établisseurs de contact (58,60) sont prévus dans le premier domaine (26) sur le côté opposé au premier espace (24), établisseurs de contact qui sont reliés, d'un côté, à chaque fois un conducteur d'amenée (36) passé au travers et, d'un autre côté, à une piste conductrice (62,64) de la carte de circuits imprimés (22) passée de façon isolée à travers les moyens protecteurs (44), cette piste conductrice (62,64) étant reliée, de son côté, par l'intermédiaire d'un établisseur de contact (66,68) à au moins l'un des composants électroniques (38) à protéger.

8. Installation selon la revendication 7, **caractérisée par le fait que** les établisseurs de contact (58,60) sont formés dans le premier domaine (26) par des établisseurs de contact à trou borgne qui ne s'étendent que du côté de la surface reliée à la masse (42) opposé au premier espace (24).

9. Installation selon l'une des revendications 1 à 8, **caractérisée par le fait que** la paroi de séparation (16) protectrice est adjacente avec sa surface frontale (20) à une piste conductrice (70) sur la surface de la carte de circuits imprimés (22) qui est en contact avec les moyens protecteurs (44) s'étirant diagonalement par rapport à la surface de la carte de circuits imprimés (22).

10. Installation selon la revendication 9, **caractérisée par le fait que** la carte de circuits imprimés (22) présente au moins à une surface frontale une surface conductrice d'électricité (72) qui est, d'un côté, adjacente au côté intérieur du boîtier (10) et qui est, de l'autre côté, en contact avec la surface interne reliée à la masse (42) de la carte de circuits imprimés (22).

11. Installation selon l'une des revendications 1 à 10, **caractérisée par le fait que** la carte de circuits imprimés comprend des composants filtrants destinés à la protection contre la surtension, par exemple la protection contre la foudre.
